Europäisches Patentamt

European Patent Office

Office européen des brevets

(11) Veröffentlichungsnummer: **0 065 999**
**B1**

(12) **EUROPÄISCHE PATENTSCHRIFT**

(45) Veröffentlichungstag der Patentschrift: 07.05.86

(51) Int. Cl.⁴: **H 01 L 27/02, G 11 C 11/40**

(21) Anmeldenummer: **81104145.8**

(22) Anmeldetag: **30.05.81**

(54) Hochintegrierter schneller Speicher mit bipolaren Transistoren.

(43) Veröffentlichungstag der Anmeldung:
08.12.82 Patentblatt 82/49

(45) Bekanntmachung des Hinweises auf die
Patenterteilung:
07.05.86 Patentblatt 86/19

(84) Benannte Vertragsstaaten:
CH DE FR GB IT LI NL SE

(56) Entgegenhaltungen:
FR-A-2 183 708
US-A-4 144 586

(73) Patentinhaber: IBM DEUTSCHLAND GMBH
Pascalstrasse 100
D-7000 Stuttgart 80 (DE)
(84) DE

(73) Patentinhaber: International Business Machines
Corporation
Old Orchard Road
Armonk, N.Y. 10504 (US)
(84) CH FR GB IT LI NL SE

(72) Erfinder: Wiedmann, Siegfried, Dr.
Im Himmel 64A
D-7000 Stuttgart 80 (DE)

(74) Vertreter: Rudolph, Wolfgang, Dipl.-Ing.
Schönaicher Strasse 220
D-7030 Böblingen (DE)

Courier Press, Leamington Spa, England.

**Beschreibung**

Die Erfindung betrifft einen hochintegrierten Speicher mit Speicherzellen aus bipolaren Transistoren nach dem Oberbegriff des Patentanspruchs 1. Ein derartiger Speicher ist aus der FR—A—2 182 708 (DE—A—2 307 739) bekannt.

Hochintegrierte Speicher, deren Speicherzellen aus bipolaren Transistoren bestehen, sind prinzipiell bekannt. So ist z.B. aus der DE—A—23 07 739 eine monolithisch integrierte Speicherzelle bekannt, die aus zwei kreuzgekoppelten Flip-Flop-Transistoren, zwei Kollektor-Lastelementen, einer zugeordneten, an die Emitter angeschlossenen Adreßleitung und einem zugeordneten Bit-Leitungspaar besteht, die dadurch charakterisiert ist, daß die Basis jedes Flip-Flop-Transistors mit dem Emitter eines zugeordneten komplementären Adressier-Transistors verbunden ist, dessen Kollektor mit der zugeordnet Bitleitung verbunden ist und dessen Basis an der Adreßleitung liegt. Die Halbleiterstruktur dieser Speicherzelle besteht aus einer ersten Zone eines ersten Leitungstyps, welche die Emitter der Flip-Flop-Transistoren und die Basen der Adressier-Transistoren bildet, weiterhin einer innerhalb der ersten Zone liegenden zweiten Zone eines zweiten Leitungstyps, welche die Basis des einen Flip-Flop-Transistors und den Emitter des zugeordneten Adressier-Transistors bildet, weiterhin einer ebenfalls in der ersten Zone liegenden dritten Zone des zweiten Leitungstyps, welche die Basis des anderen Flip-Flop-Transistors und den Emitter des zugeordneten Adressier-Transistors bildet, einer innerhalb der zweiten Zone liegenden vierten Zone des ersten Leitungstyps, welche den Kollektor des einen Flip-Flop-Transistors bildet, weiterhin einer innerhalb der ersten Zone liegenden fünften Zone des ersten Leitungstyps, welche den Kollektor des anderen Flip-Flop-Transistors bildet, weiter einer innerhalb der ersten Zone liegenden sechsten Zone des zweiten Leitungstyps, welche den Kollektor des einen Adressier-Transistors bildet, und einer innerhalb der ersten Zone liegenden sechsten Zone des zweiten Leitungstyps, welche den Kollektor des anderen Adressier-Transistors bildet.

Diese MTL-Speicherzelle weist bereits das Merkmal auf, daß die Lese- und Schaltsignale durch Injektionskopplung an die Bitleitungen gelangen. Beim Lesen wird ein Teil des Primärinjektorstroms über das Basisgebiet des NPN-Transistors den Bitleitungs- und den Gate-Transistor zugeführt, dessen Kollektorstrom das Lesesignal bildet. Durch diese hierdurch bekanntgewordene Art der Injektionskopplung ist es möglich, Halbleiterstrukturen für Speicherzellen aufzubauen, die eine sehr dichte Anordnung der Speicherzellen innerhalb eines Speicherzellenverbands ermöglichen. Der Nachteil dieser Speicherzellen-Strukturen besteht jedoch darin, daß nur ein relativ kleiner Lesestrom ermöglicht wird, bedingt durch das hochohmige Bahngebiet des NPN-Basisgebietes. Der relativ kleine Lesestrom begrenzt seinerseits die Lesegeschwindigkeit wesentlich.

Außerdem ist in der DE—OS 26 12 666 eine hochintegrierte, invertierende logische Schaltung bekannt geworden, mit einer einen invertierenden Transistor bildenden Zonenfolge, der über ein Injektionsgebiet in der Nähe des Basis-Emitterübergangs durch Injektion von Ladungsträgern mit Betriebsstrom versorgt und an der Basis gesteuert wird. Diese Schaltung ist dadurch charakterisiert, daß an das Injektionsgebiet eine Abfühlschaltung angeschlossen ist, über die der Leitzustand des invertierenden Transistors aufgrund des bei leitendem Transistor in das Injektionsgebiet rückinjizierten Stromes abgefühlt wird. Der invertierende Transistor besteht dabei aus einer invers betriebenen vertikalen Transistorstruktur mit auf einer einem Halbleitermaterial aufgebrachten und die Emitterzone bildenden Halbleiterschicht, in der die die Kollektorzone enthaltende Basiszone angeordnet ist. Lateral zur Basiszone ist das Injektionsgebiet gleichen Leitfähigkeitstyps angeordnet, das gleichzeitig für die Stromzuführung als Emitter und für das Abfühlen des Leitzustandes des invertierenden Transistors als Kollektor eines lateralen Transistors dient.

Hier ist also das Bitleitungs-Injektorgebiet mit dem Primärinjektor zusammengefaßt, so daß der Strom nicht mehr durch das hochohmige NPN-Basisgebiet fließen muß. Der Nachteil dieser Schaltung besteht jedoch darin, daß ein nur relativ sehr kleines Spannungssignal $\Delta V$ zwischen den beiden Leitungsinjektoren auftritt, wodurch die Lesegeschwindigkeit bei der Verwendung in einem Speicher oder auch bei der Verwendung in einem programmierbaren logischen Schaltungsverband nachteilig beeinflußt wird, d.h. zu niedrig wird.

Der Erfindung liegt deshalb die Aufgabe zugrunde, einen Speicher mit Speicherzellen aus bipolaren Transistoren zu schaffen, wobei die Struktur der Speicherzelle eine sehr flexible Anpassung der Injektions-Koppeleigenschaften an die elektrischen und physikalischen Anforderung der Speicherzelle ermöglicht und die außerdem durch unterschiedliche Dimensionierung sowohl der Basisweiten als auch der Injektolängen optimal auf die jeweiligen Prozeß-, Schaltungs- und Layout-Parameter zugeschnitten werden kann, wobei vor allem ein relativ großes Lesesignal erzeugt werden soll, um wesentlich bessere Lesegeschwindigkeiten als bisher erreichen zu können.

Die erfindungsgemäße Lösung ergibt sich aus dem Kennzeichen des Patentanspruchs 1.

Besondere Ausführungsarten der Erfindung sind in den Patentansprüchen 2 bis 10 charakterisiert.

Durch den winkelförmigen Ladungsträgerfluß zwischen den lateralen P-Gebieten ist eine Struktur geschaffen worden, die eine sehr flexible Anpassung der Injektions-Koppeleigenschaften an die elektrischen und physikalischen Anforderungen der Speicherzelle erlaubt. Im Gegensatz zu den bisher bekanntgewordenen MTL-Speicherzellen ist durch unterschiedliche Dimensionierung sowohl der Basisweiten als auch
der Injektorlängen die Speicherzelle optimal
auf die jeweiligen Prozeß, Schaltungsanordnungs- und Layout-Parameter anzupassen.
Die parasitären Kopplungen lassen sich in
bekannter Weise durch geeignete Inhibitoren
unschädlich machen.

Die winkelförmige und in Spezialfalle die
orthogonale Injektionskopplung ermöglichen vor
allem einen relativ niederohmigen Bahnverlauf
des Signalpfades, wodurch große Sekundärinjektionsströme und damit große Lesesignale
erzeugt werden können. Die Lesespannungsdifferenz nimmt im Gegensatz zu den bisher
bekanntgewordenen MTL-Zellen bei kleineren
Stromverstärkungen der PNP-Transistoren nicht
ab, so daß beinahe beliebig große Zellströme für
die Leseoperation zugeführt werden können.
Durch den günstigen Bahngebietsverlauf kann die
Speicherzelle auch ohne weiteres in einem
Prozeß hergestellt werden, der eine Top-
Kollektor-Begrenzung mit dielektrischer Isolation
vorsieht. Ein wesentlicher weiterer Vorteil besteht
noch darin, daß beim Betrieb der Speicherzelle
innerhalb einer Speichermatrix verschiedene
Adressiersysteme möglich sind. Eine optimale
Anpassung an die äußeren Randbedingungen
wie Speichergröße, Leistung, Geschwindigkeit,
Prozeßeigenschaften, Speicherzellendichte ist dadurch möglich.

Die Erfindung wird nun anhand eines in der
Zeichnung dargestellten Ausführungsbeipiels
näher erläutert.

Es zeigen:

Fig. 1 ein Schaltbild einer Speicherzelle mit
bipolaren Transistoren;

Fig. 2 die Draufsicht auf ein Layout mit
orthogonaler Injektionskopplung;

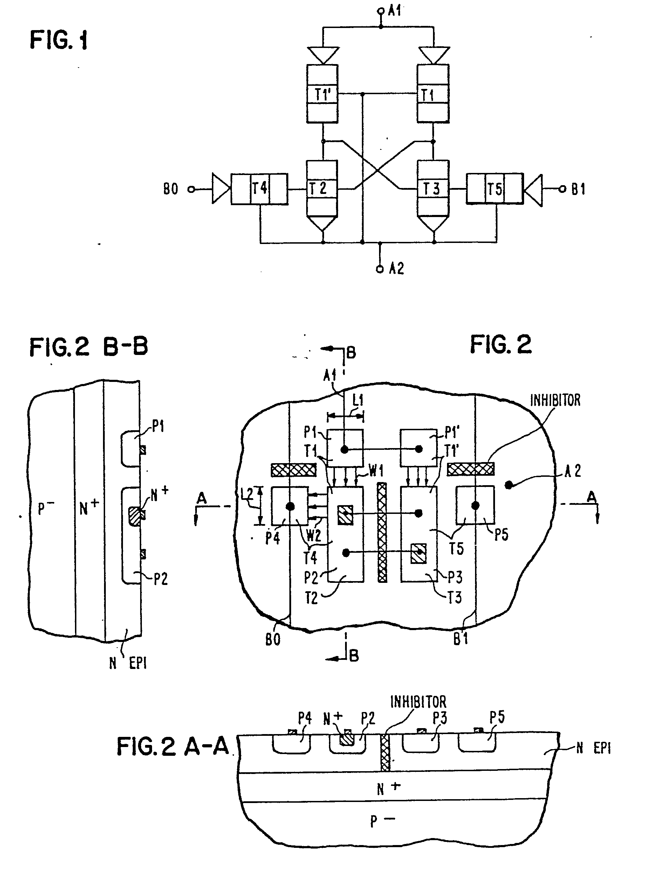

Fig. 2A—A, 2B—B Schnitte durch die Halbleiterstruktur gemäß Fig. 2;

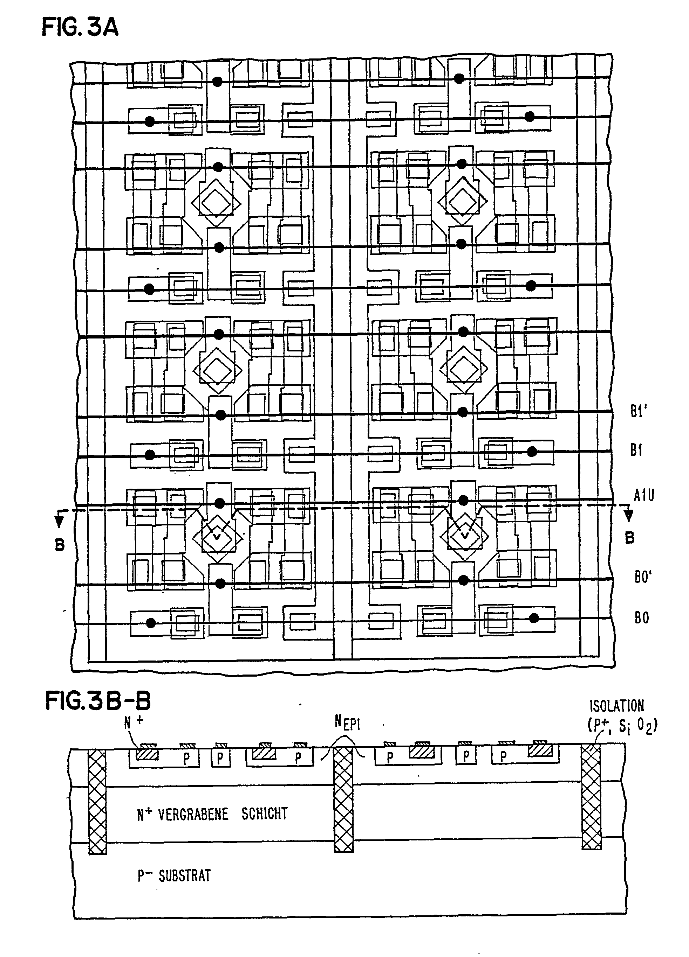

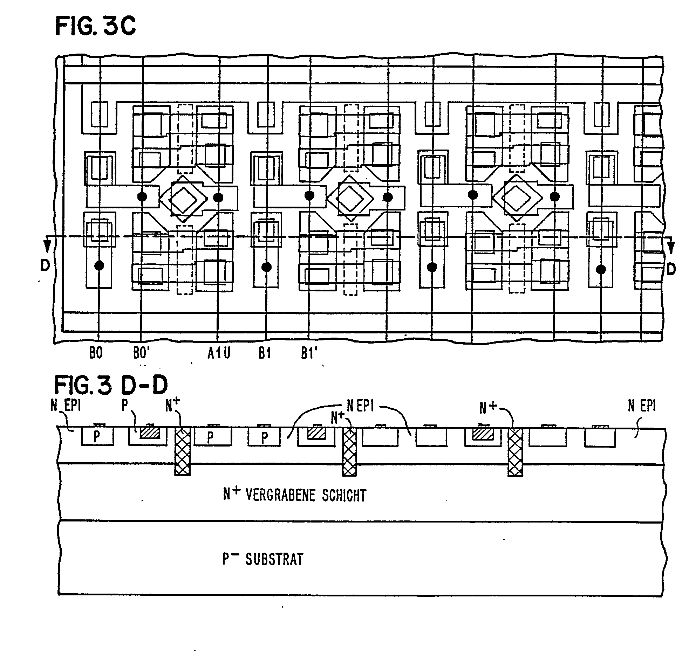

Fign. 3A, 3B—B, 3C—C und 3D—D einen Ausschnitt aus einem hochintegrierten Halbleiterspeicher mit den zugehörigen Schnitten durch
den Halbleiterkörper und

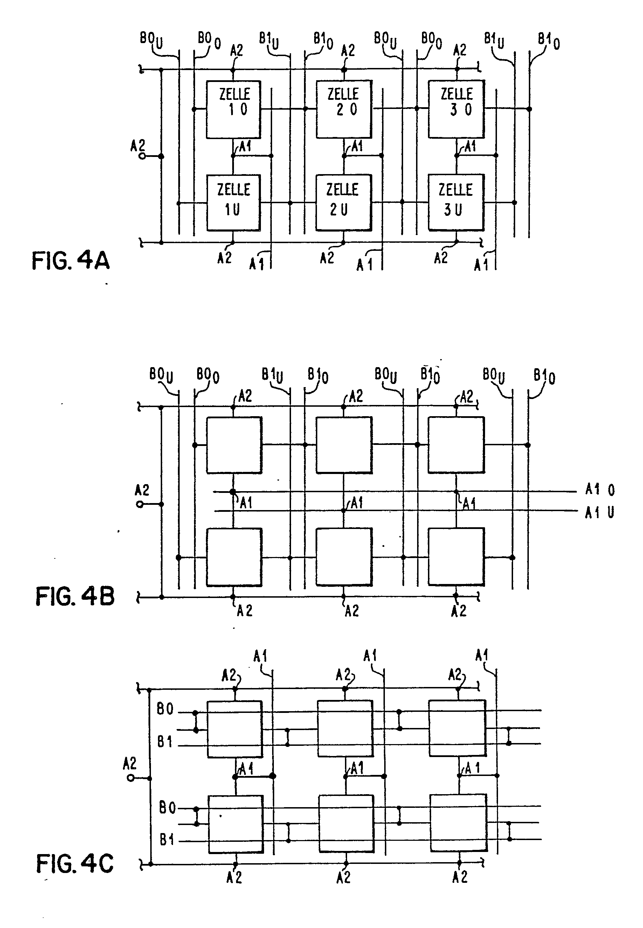

Fign. 4A bis C Schematische Schaltbilder zur
vorteilhaften Adressierung der Speicherzellen in
einem Speicherzellenverband.

In Fig. 1 ist zunächst ein Schaltbild einer
Speicherzelle, die aus bipolaren Transistoren
besteht, gezeigt, die sich besonders für die
weinkelförmige Injektionskopplung eignet. Diese
Speicherzelle nach Fig. 1 besteht aus den kreuzgekoppelten Flip-Flop-Transistoren T2 und T3 die
mit ihren Emittern gemeinsam an dem
Adressierungspunkt A2 angeschlossen sind. An
diesem Adressierungspunkt A2 sind außerdem
die Basen der beiden Bitleitungstransistoren T4
und T5 angeschlossen, die außerdem sowohl mit
den Bitleitungen B0/B1 als auch mit den kreuzgekoppelten Flip-Flop-Transistoren T2 bzw. T3 verbunden sind. Außerdem sind in dieser Speicherzelle Lasttransistoren T1 und T1′ vorhanden,
deren Basen gemeinsam ebenfalls mit dem Adressierungspunkt A2 verbunden sind. Des
weiteren sind die Emitter dieser Transistoren T1
und T1′ mit einem Adressierungspunkt A1 verbunden, um die Zelle in einem Zellenverband
Adressieren und Selektieren zu können.

Eine Speicherzellen-Struktur mit winkelförmiger Injektionskopplung ist nun in Fig. 2
dargestellt. Vor der detaillierten Beschreibung
dieser Figur soll noch erwähnt sein, daß die
Transistoren T1, T1′, T2, T3, T4 und T5, die die
Speicherzellen nach Fig. 1 bilden in der Fig. 2 in
hochintegrierter Form vorhanden sind und als
solche mit den gleichten Bezugszeichen versehen
sind. Aus der Darstellung der Fig. 2 sind ganz klar
die beiden Bitleitungen B0 und B1 sowie die
beiden Adressierungspunkte A1 und A2 zu
erkennen. Eine orthogonale als Spezialfall der
winkelförmigen Injektion ist durch in die Fig. 2
eingezeichnete Pfeile dargestellt worden.

Wie aus den Schnitten der Fign. 2A—A und
2B—B hervorgeht, sind die Speicherzellen innerhalb einer Halbleiterschichtfolge (von unten her
gesehen P−, N+ und in N-Epitaxie) angeordnet.
Die Transistoren T1 bzw T1′ werden von den
Gebieten P1 bzw P1′ innerhalb der N-Epitaxie-Schicht und jeweils einem weiteren P-Gebeit
innerhalb der N-Epitaxie-Schicht, nämlich P2 bzw.
P3 gebildet. Die Transistoren T2 und T3 des
Flip-Flops werden ebenfalls durch die Gebiete P2
bzw. P3 innerhalb der N-Epitaxie-Schicht gebildet,
wobei innerhalb des P2-bzw. P3-Gebietes ein N+
Gebiet angeordnet ist. Der mit der Bitleitung B0
verbundene Transistor T4 wird durch das P-
Gebiet P4 innerhalb der N-Epitaxie-Schicht und
dem benachbarten P-Gebiet P2 gebildet. Der mit
der Bitleitung B1 verbundene Transistor T5 der
Speicherzelle nach Fig. 1 wird durch das in Der
N-Epitaxie-Schicht eingebettete Gebiet P5 und
das benachbarte P3-Gebiet gebildet. Die beiden
P-Gebiete P1 und P1′ sind metallisch miteinander
und zusammen mit dem Anschlußpunkt A1, im
gegebenen Falle über eine weitere Leitung wie
schematisch in Fig. 2 angedeutet, verbunden. Um
parasitäre Kopplungen zu vermeiden, sind sie
kreuzgestrichelten Inhibitoren in der Halbleiterstruktur angeordnet.

Wie nun aus der Fig. 2 zu ersehen ist, ist eine
derartige Struktur durch einen orthogonalen
Ladungsträgerfluß zwischen den lateralen P-
Gebieten charakterisiert. Mit den als Primärinjektoren bezeichnete P-Gebieten P1, P1′ wird
der Zellstrom in die Basisgebiete P2, P3 der
invertierten NPN-Flip-Flop-Transistor-Strukturen
T2 und T3 injiziert. Ein Teil dieses Stromes wird
vom jeweiligen eingeschalteten Transistor in das
benachbarte P-Gebiet der Bitleitungsinjektoren P4
bzw. P5 injiziert. Durch diese Maßnahme kann der
Schaltzustand der Speicherzelle abgefragt
werden. Diese orthogonale Injektions-Kopplung
ermöglicht vor allem einen relativ niederohmigen Bahnverlauf, wodurch große Sekundär-Injektionsströme und damit große Lesesignale erzeugt werden können. Die Lesespannungsdifferenz nimmt nicht bei kleineren Stromverstärkungen der PNP-Transistoren ab, so daß beinahe beliebig große Zellströme für die Leseoperation zugeführt werden können, wodurch sich die Lesegeschwindigkeit erhöht. Durch den großzügigen Bahngebietsverlauf kann die Speicherzelle auch ohne weiteres in einem Prozeß hergestellt werden, die eine Top-Kollektor-Begrenzung mit dielektrischer Isolation vorsieht.

Außerdem erlaubt die in Fig. 2 gezeigte Struktur einer Speicherzelle eine sehr flexible Anpassung der Injektions-Koppeleigenschaften an die elektrischen und physikalischen Anforderungen der Speicherzelle innerhalb eines Speichers. Im Gegensatz zu den bisher bekanntgewordenen MTL-Speicherzellen kann man nämlich hier durch unterschiedliche Dimensionierung sowohl der Basisweiten W1 und W2 als auch der Injektorlängen L1 und L2 die Speicherzelle nach Fig. 2 optimal auf die jeweiligen Prozeß-, Schaltungs-, Layout-Parameter einschließlich der Toleranzen zuschneiden.

Für den Betrieb einer Speicherzelle nach Fig. 2 innerhalb einer Speichermatrix sind verschiedene Adressiersysteme möglich, wobei die jeweils optimale Methode von äußeren Randbedingungen wie Speichergröße, Speicherdichte, Leistung, Geschwindigkeit, Prozeßeigenschaften usw. abhängig ist. Verschiedene sehr vorteilhafte Adressiersysteme in Verbindung mit der Speicherzelle nach Fig. 1 werden später beschrieben und sind in den Fig. 4A bis 4C angegeben. Diese Flexibilität ist von entschiedendem Vorteil bei hochdichten Speichermatrizen, da eine durch diese Art der erfindungsgemäßen Injektion hervorgerufene Struktur erste eine optimale Auslegung ermöglicht.

Für den Lesevorgang wird die Speicherzelle nach Fig. 2 dadurch aktiviert, daß die Spannung der Primärinjektoren P1 und P1', die zwischen den Adressieranschlüssen A1 und A2 liegen, gegenüber den nicht- oder halbselektierten Speicherzellen innerhalb des Speicherverbandes entsprechend erhöht wird. Der daraus resultierende Bitleitungsstrom wird in einem nicht dargestellten bekannten Leseverstärker zwischen B0 und B1 abgefühlt.

Beim Schreiben wird dagegen der Zellstrom der selektierten Speicherzelle innerhalb des Speicherverbands abgeschlatet und ein entsprechender Schreibstrom über den Bitleitungsinjektor P4 bzw. P5 zugeführt, die die jeweilige Speicherzelle in eine bestimmte Lage zwingt.

Der Adreßanschluß A2 verläuft als Adreßleitung (N-Wanne) oder als Metalleitung, die diese N-Wanne oder N-Gebiete kontaktiert senkrecht zu den Betleitungen B0 und B1, um mit Hilfe einer XY-Selektion den Schreibstrom lediglich in den Bitleitungsinjektor der selektierten Speicherzelle einzuprägen. Der Adressieranschluß A1 in Form einer metallischen Leitung kann entweder parallel oder senkrecht zur Adreßleitung A2 verlaufen. Die beiden Fälle bewirken unterschiedliche kapazitive Selektionsströme aufgrund unterschiedlicher Entladeströme von Zellkapazitäten der halb- oder nichtselektierten Speicherzellen. Daraus ergibt sich ein weiterer zusätzlicher Freiheitsgrad zwischen Komplexität der peripheren Schaltkreise Geschwindigkeit und der Leistung des Speichers.

In Fig. 3A ist nun eine Draufsicht auf einen Ausschnitt aus einer Speichermatrix gezeigt, die aus Speicherzellen gemäß Fig. 1 besteht und die winkelförmige Injektions-Kopplung benützt, wobie hier nochmals eine höhere Integrationsdichte im Vergleich zu der Struktur in Fig. 2 erreicht wird.

In den Fign. 3B—B und 3C—C sind die in Fig. 3A angegebenen Schnitte dargestellt. Wie aus Fig. 3A zu ersehen ist, verlaufen hier jeweils zwei Bitleitungen B0 und B0' bzw. B1 und B1' als Leitungspaare, senkrecht zu den durch senkrecht bis zum P-Substrat reichende Isolationsstreifen getrennten N-Epitaxiestreifen. Zwischen den jeweils paarig angeordneten Bitleitungen B0, B0' und B1, B1' ist außerdem der Adressieranschluß A1 in Form einer parallel zu den Bitleitungen verlaufenden Leitung A1 U angeordnet. Diese Anordnung der Bitleitungen B0, B0' usw. ergibt sich aus der Zusammenfassung zweier Zellen zum Zwecke einer noch höheren Integrationsdichte im Vergleich zu der in Fig. 2 dargestellten Struktur. Die Primärinjektoren P1, P1' nach Fig. 2 sind somit für zwei Speicherzellen gemeinsam, was insbesondere aus den Fign. 3A und 3B—B klar hervorgeht.

In Fig. 3C ist eine weiter Draufsicht auf das in Fig. 3A dargestellte Layout gezeigt, um den senkrechten Schnitt D in der Fig. 3D—D besser darstellen zu können. In diesem Schnitt sind auch deutlich die Isolatoren bzw. Inhibitoren aus N+ Material zu sehen, die eine schädliche Kopplung zwischen den Primärinjektoren und den anderen P-Gebieten verhindern. Außerdem haben in dieser Ausführung zwei benachbarte Speicherzellen gemeinsame Bitleitungsinjektoren wie aus den Zeichnungen zu ersehen ist. Durch diese Maßnahmen war es möglich, unte Zugrundelegung eines bisher bekannten Prozesses eine bis zu 30% höhere Dichte bei wesentlich besserer Lesegeschwindigkeit zu erreichen.

Zusammenfassen ergibt sich, daß durch die Strukturen sowohl nach der Fig. 2 als auch nach der Fig. 3 eine sehr große Dichtesteigerung gegenüber den bisher bekanntgewordenen Speicherzellen ergeben und gleichzeitig ein sehr großes Lesesignal und zwar sowohl Strom als auch Spannung erzielt wird. In den nachfolgend kurz beschriebenen Fign. 4A bis 4C sind vorteilhafte Selektionsschemata für Speicherzellen in einem Matrixverband gezeigt. In allen Fign. sind dabei zwei Zeilen Speicherzellen nämlich 1 O bis 3 O und 1 U bis 3 U gezeigt. Die Zellen der oberen und der unteren Reihe 1 O bis 3 O bzw 1 U bis 3 U liegen gemeinsam an den einen Adressierungsanschluß A2, während die jeweils untereinanderliegenden Zellen im Verband, nämlich 1 O, 1 U bzw. 2 O, 2 U usw. gemeinsam an dem zweiten Adressierungsanschluß A1 anliegen. Außerdem sind getrennte Bitleitungen für die obere Reihe 1 O bis 3 O und für die untere Reihe 1 U bis 2 U vorhanden, die mit B0 U bzw. B0 O oder B1 U bzw. B1 O bezeichnet sind. In Fig. 4B ist ein weiteres Ausführungsbeispiel für ein Selektionsschema gezeigt, daß sich von dem in der Fig. 4A gezeigten nur darin unterscheidet, daß die Adressierungsanschlüsse A1 für die Speicherzellen der oberen Reihe und der unteren Reihe an je eine separate Leitung A1 O bzw A1 U geführt sind.

In Fig. 4C ist eine weiter Modifikation des Selektionsschemas der Fig. 4A dargestellt, wobei die Verbindung zu den Adressierungsanschlüssen A1 und A2 gleich bleibt, jedoch die Ausführung und Verbindung der Bitleitungen B1 und B0 anders ist. Hier werden wie im klassischen Sinne die Bitleitungspaare B0/B1 zusammen parallel geführt, wobei die Verbindung der Speicherzellen mit den Bitleitungen über jeweils eine weitere zwischen den Speicherzellen liegende Leitung erreicht wird. Durch diese Maßnahme ist hier nur eine senkrecht verlaufende Leitung zu allen anderen verlaufenden Leitungen vorhanden.

## Patentansprüche

1. Speicher mit statischen MTL-Speicherzellen in Kreuzungspunkten von Wort- und Bitleitungen, wobei die Lese- und Schreibsignale durch Injektionskopplung an die Bitleitungen gelangen, bei dem in jeder Speicherzelle Primärinjektoren (P1, P1') einen Zellstrom in die Basisgebiete (P2, P3) von NPN-Flipflop-Transistoren (T2, T3)· der Speicherzelle injizieren und bei dem ein Teil dieses Stroms vom jeweils eingeschalteten Flip-flop-Transistor (T2 oder T3) in jeweils einen ihm benachbarten lateralen Bitleitungsinjektor (P4, P5) injiziert wird, dadurch gekennzeichnet, daß jeweils ein Primärinjektor (P1 oder P1') und ein Bitleitungsinjektor (P4 oder P5) über das Basisgebiet (P2, P3) des jeweils eingeschalteten Flip-flop-Transistors (T2 oder T3) durch eine Injektionskopplung mit lateral und winkelförmig ver-laufendem Ladungsträgerfluß miteinander ver-koppelt sind, und daß die Signalstrompfade vom Primärinjektor zum Bitleitungsinjektor . niederohmige Bahngebiete aufweisen.

2. Speicher nach Anspruch 1, dadurch gekennzeichnet, daß die niederohmigen Bahngebiete mindestens die Basisgebiete er Flip-flop-Transistoren umfassen.

3. Speicher nach Anspruch 1, dadurch gekennzeichnet, daß im Signalstrompfad vom Primärinjektor (P1, P1') zum Bitleitungsinjektor (P4, P5) niederohmige Bereiche für einen orthogonal verlaufenden Ladungsträgerfluß der Injektions-kopplung angeordnet sind.

4. Speicher nach einem der Ansprüche 1 bis 3, dadurch gekennzeichnet, daß für mindestens zwei benachbarte Speicherzellen ein gemeinsamer Primärinjektor (P1) angeordnet ist und/ oder daß für mindestens zwei benachbart ange-ordnete Speicherzellen gemeinsame Bitleitungs-injektoren (P4, P5) vorhanden sind.

5. Speicher nach den Ansprüchen 1 bis 4, dadurch gekennzeichnet, daß eine Adreßleitung (A1, A2) senkrecht zu den metallischen Bitleitungen (B0, B1) angeordnet ist, um mit Hilfe einer X—Y-Selektion den Schreibimpuls in einem Bitleitungsinjektor (P4 oder P5) der selektierten Speicherzellen einzuprägen.

6. Speicher nach Anspruch 5, dadurch gekennzeichnet, daß die Adreßleitung des einen Anschlußpunktes (A1) parallel zur Adreßleitung des anderen Anschlußpunktes (A2) verläuft und als metallische Leitung oder aus Polysilizium ausgeführt ist.

7. Speicher nach Anspruch 5, dadurch gekennzeichnet, daß die Adreßleitung des einen Anschlußpunktes (A1) senkrecht zur Adreßleitung des anderen Anschlußpunktes (A2) angeordnet ist und als metallische Leitung oder aus Polysilizium ausgeführt ist.

8. Speicher nach den Ansprüchen 1 bis 4, dadurch gekennzeichnet, daß die Bitleitungen parallel zu den Adreßleitungen angeordnet sind.

9. Speicher nach den ·Ansprüchen 1 bis 7, dadurch gekennzeichnet, daß zum Lesen einer in der Speicherzelle gespeicherten Information die Spannung an den Primärinjektoren (P1, P1') zwischen den Adreßanschlüssen bzw. -leitungen (A1 und A2) gegenüber den nicht- oder halbselektierten Speicherzellen erhöhbar ist und daß der daraus resultierende Bitleitungsstrom von einem mit den Bitleitungen (B0 und B1) ver-bundenen Leseverstärker abfühlbar ist.

10. Speicher nach den Ansprüchen 1 bis 7, dadurch gekennzeichnet, daß zum Schreiben der Strom im Primärinjektor (P1, P1') der selektierten Speicherzelle abschaltbar ist und ein entsprechender Schreibstrom über den betreffenden Bitleitungsinjektor (z.B. P4) zuführbar ist.

## Revendications

1. Mémoire avec cellules de mémoire MTL statique placées en des points du croisement de conducteurs de mots et de bits, les signaux de lecture et d'écriture parvenant par couplage par injection aux conducteurs de bits, dans laquelle dans chaque cellule des injecteurs primaires (P1, P1') injectent un courant de cellules dans les zones de base (P2, P3) de transistors de bascule NPN (T2, T3) de la cellule de mémoire et dans laquelle une partie de ce courant est injectée par un transistor de bascule (T2 ou T3) respectivement conducteur dans un injecteur latéral de conducteurs de bits P4, P5) qui lui est adjacent, caractérisée en ce que respectivement un injecteur primaire (P1 ou P1') et un injecteur de conducteur de bits (P4 ou P5) sont couplés entre eux par l'intermédiaire de la zone de base (P2, P3) du transistor de bascule (T2 ou T3) respectivement conducteur par un couplage par injection avec un flux de porteurs de charge se propageant latéralement et avec un profil anguleux, et en ce que les voies de courant de signal entre un injecteur primaire et un injecteur de conducteur de bits présentent des zones de faible valeur ohmique.

2. Mémoire selon la revendication 1, caractérisée en ce que les zones de voie de faible valeur ohmique comprennent au moins les zones de base de transistors de bascule.

3. Mémoire selon la revendication 1, caractérisée en ce que, dans une voie de courant de signal entre un injecteur primaire (P1, P1') et un injecteur de conducteur de bits (P4, P5), il est prévu des zones de faible valeur ohmique pour un flux de porteurs de charge du complage par injection qui est orienté orthogonalement.

4. Mémoire selon l'une des revendications 1 à 3, caractérisée en ce que, pour au moins deux cellules de mémoire adjacentes, il est prévu un injecteur primaire commun (P1) et/ou en ce que, pour au moins deux cellules de mémoire placées dans des positions adjacentes, il est prévu des injecteurs de conducteurs de bits communs (P4, P5).

5. Mémoire selon les revendications 1 à 4, caractérisée en ce qu'un conducteur d'adressage (A1, A2) est disposé perpendiculairement aus conducteurs de bits métalliques (B0, B1), pour introduire, au moyen d'une sélection X—Y, l'impulsion d'écriture dans un injecteur de conducteur de bits (P4 ou P5) des cellules sélectionnées dans la mémoire.

6. Mémoire selon la revendication 5, caractérisée en ce que le conducteur d'adressage d'un des points de connexion (A1) est orienté parallèlement au conducteur d'adressage de l'autre point de connexion (A2) et réalisé sous forme d'un conducteur métallique ou bien en polysilicium.

7. Mémoire selon la revendication 5, caractérisée en ce que la conducteur d'adressage d'un des points de connexion (A1) est disposé perpendiculairement au conducteur d'adressage de l'autre point de connexion (A2) et est réalisé sous forme d'un conducteur métallique ou en polysilicium.

8. Mémoire selon les revendications 1 à 4, caractérisée en ce que les conducteurs de bits sont disposés parallèlement aux conducteurs d'adressage.

9. Mémoire selon les revendications 1 à 7, caractérisée en ce que, pour la lecture d'une information mémorisée· dans la cellule de mémoire, la tension appliquée aux injecteurs primaires (P1, P1') entre les connexions ou conducteurs d'adressage (A1 et A2) peut être augmentée par rapport aux cellules non sélectionnées ou à demisélectionnées de la mémoire et en ce que le courant de conducteurs de bits en résultant peut être détecté par un amplificateur de lecture relié aux conducteurs de bits (B0 et B1).

10. Mémoire selon les revendications 1 à 7, caractérisée en ce que, pour l'écriture, le courant dans un injecteur primaire (P1, P1') de la cellule sélectionnée de la mémoire peut être arrête et un courant d'écriture correspondant peut être appliqué par l'intermédiaire de l'injecteur de conducteur de bits associé (P4).

**Claims**

1. Memory with static MTL memory cells at the crossings of word and bit lines, wherein the read and write signals reach the bit lines by injection coupling, wherein in each memory cell primary injectors (P1, P1') inject a cell current into the base regions (P2, P3) of NPN flip-flop transistors (T2, T3) of the memory cell, and wherein part of that current is injected by the respective conducting flip-flop transistor (T2 or T3) into an adjacent lateral bit line injector (P4, P5), characterized in that one primary injector (P1 or P1') and one bit line injector (P4 or P5) through the base region (P2, P3) of the respective conducting flip-flop transistor (T2 or T3) are in each case coupled by injection coupling with a lateral and an angular charge carrier flow, and that the signal current paths from the primary injector to the bit line injector comprise low-resistivity path regions.

2. Memory according to claim 1, characterized in that the low-resistivity path regions comprise at least the base regions of the flip-flop transistors.

3. Memory according to claim 1, characterized in that low-resistivity regions for an orthogonal charge carrier flow of the injection coupling are positioned in the signal current path from the primary injector (P1, P1') to the bit line injector (P4, P5).

4. Memory according to any one of the claims 1 to 3, characterized in that for at least two adjacent memory cells one common primary injector (P1) is provided and/or that for at least two adjacent memory cells there are common bit line injectors (P4, P5).

5. Memory according to any one of the claims 1 to 4, characterized in that an address line (A1, A2) is perpendicularly arranged relative to the metallic bit lines (B0, B1) in order to impress the write pulse by X—Y selection into a bit line injector (P4 or P5) of the selected memory cells.

6. Memory according to claim 5, characterized in that the address line of one node (A1) is arranged parallel to the address line of the other node (A2) and is designed as a metallic conductor or is made of polysilicon.

7. Memory according to claim 5, characterized in that the address line (A1) of one node (A1) is arranged perpendicularly to the address line of the other node (A2) and is designed as a metallic conductor or is made of polysilicon.

8. Memory according to any one of the claims 1 to 4, characterized in that the bit lines are arranged parallel to the address lines.

9. Memory according to claims 1 to 7, characterized in that for reading information stored in the memory cell, the voltage at the primary injectors (P1, P1') between the address nodes or lines (A1 and A2) is increased over that of the non- or semi-selected memory cells, and that the bit line current resulting therefrom is sensed by a read amplifier connected to the bit lines (B0 and B1).

10. Memory according to claims 1 to 7, characterized in that for writing, the current in the primary injector (P1, P1') of the selected memory cell is switched off and a suitable write current is applied via the respective bit line injector (e.g., P4).

# FIG. 1

# FIG.2 B-B

# FIG. 2

# FIG.2 A-A

## FIG. 3A

B1'
B1
A1U
B
B
B0'
B0

## FIG. 3 B-B

N +

$N_{EPI}$

ISOLATION
$(P^+, S_i O_2)$

P    P    P    P

$N^+$ VERGRABENE SCHICHT

$P^-$ SUBSTRAT

## FIG. 3C

BO     BO'       A1U     B1     B1'

## FIG. 3 D-D

N EPI    P    N⁺              N EPI                 N⁺          N EPI

N⁺

P    P        P   P

$N^+$ VERGRABENE SCHICHT

$P^-$ SUBSTRAT

FIG. 4A

FIG. 4B

FIG. 4C